Europäisches Patentamt

European Patent Office

Office européen des brevets

(11) Publication number: **0 130 552**
**B1**

(12) **EUROPEAN PATENT SPECIFICATION**

(45) Date of publication of patent specification: **12.09.90**

(21) Application number: **84107400.8**

(22) Date of filing: **28.06.84**

(51) Int. Cl.⁵: **H 01 L 23/48, H 01 L 21/56**

(54) Electronic device method using a leadframe with an integral mold vent means.

(30) Priority: **29.06.83 US 508955**

(43) Date of publication of application:
**09.01.85 Bulletin 85/02**

(45) Publication of the grant of the patent:
**12.09.90 Bulletin 90/37**

(84) Designated Contracting States:
**DE FR GB IT**

(56) References cited:
**US-A-3 444 440**
**US-A-3 950 140**

**PATENTS ABSTRACTS OF JAPAN, vol. 8, no. 115 (E-247)1552r, 29th May 1984; & JP - A - 59 29 442 (MITSUBISHI DENKI K.K.) 16-02-1984**

(73) Proprietor: **MOTOROLA, INC.**
**1303 East Algonquin Road**
**Schaumburg, IL 60196 (US)**

(72) Inventor: **Kirk, Glenn E.**
**1870 West Navarro**
**Mesa Arizona 85202 (US)**

(74) Representative: **Hudson, Peter David**
**Motorola Ltd. Patent and Licensing Operations -**
**Europe Jays Close Viables Industrial Estate**
**Basingstoke Hampshire RG22 4PD (GB)**

Courier Press, Leamington Spa, England.

## Description

Background of the invention
Field of the invention

This invention relates to improved means and methods for electronic devices and, more particularly, to an improved leadframe containing integral mold vents for plastic encapsulation, to the methods of use, and to improved devices produced thereby.

Description of the prior art

Ladder-like leadframes are widely used in the production of electronic devices particularly semiconductor devices and integrated circuits. An example of such a leadframe can be found in US—A—3 950 140. Typically, the ladder-leadframe has a small central metal pad or flag to which a semiconductor die is attached. The die flag is surrounded by other portions of the leadframe which serve as leads. These leads provide the external connections and protrude from the finished package after plastic has been molded around the die. Tie bars or strips serve to hold the flag and leads of the individual device unit together, and to couple a multiplicity of individual units into a long ladder-like strip for convenient handling during manufacture. Each unit resembles the rung on a ladder. The tie bars or strips running along the edges of the ladder are called rails. Once the semiconductor die has been placed on the die flag and any required wire bonds made from the die to the leads, the ladder-leadframe containing the die is placed in a mold for encapsulation. When the mold is closed the periphery of each mold cavity seals against the tie bars or tie strips so as to provide a closed space or cavity surrounding each die. Plastic is then injected into this closed space or cavity in order to provide the encapsulation. In order that the plastic may properly enter the enclosed die cavity, provision must be made to vent each cavity so that the gases contained within the cavity can escape ahead of the in-rushing plastic. It has been common practice to provide small holes or channel in the mold for this purpose. These are called mold vents. If mold vents are omitted or become plugged some of the gases contained in the cavity become trapped in the plastic encapsulation making it porous. This adversely affects product quality and is undesirable.

Each time a set of devices is encapsulated, the mold vents become filled with plastic. Consequently, when the mold is opened and the encapsulated parts removed, before another set of leadframes can be placed in the mold for a second production cycle, the hardened plastic left behind in the mold vents must be removed. Because the mold vents are quite small, particularly in connection with the encapsulation of electronic devices such as transistors or integrated circuits, cleaning of the mold vents is usually accomplished by hand. This is an expensive procedure.

Further, most leadframes are produced by stamping which leaves a slight burr at the edges of the leadframes. When the mold closes, these burrs frequently protrude into the mold vents partially obstructing them. This increases the probability that gas will be trapped in the plastic encapsulation, adversely affecting product quality.

Additionally, the fine geometry grooves or holes used for the mold vents are easily damaged by the relatively abrasive plastic materials or through operator error due to improper cleaning or use of the mold press. As a consequence, manufacturing costs are increased both because additional labor is required and because mold life is shortened.

A need continues to exist for molding means and methods which avoid these problems. Accordingly, it is an object of the present invention to provide improved means and method for encapsulating electronic devices.

According to the present invention, a leadframe for use in plastics encapsulation of electronic devices is provided comprising

device support means located in a central region of the leadframe, and

lead means extending from the device support means to an edge or edges of the leadframe, and tie-bars interconnecting the lead means, the tie-bars being connected to side rails, characterised by:

multiple V-shaped vent channels formed in a surface of the leadframe, extending across at least one of the tie-bars and/or at least one of the side rails for venting gases during the plastics encapsulation.

According to further aspects of the invention, there is provided a leadframe according to claim 2 and a method for plastic encapsulation of an electronic device according to claim 6. The invention also provides for a semiconductor device including the above leadframe.

An improved electronic device results from the utilization of a leadframe having molding vent means integral with the leadframe, which reduces the occurrence of trapping gas bubbles within the plastic encapsulation due to incomplete venting of the mold during plastic injection and curing.

As used herein, the words "mold vent" refers to channels, grooves, or holes formed in the body of a mold to permit gases compressed during injection of the plastic to escape from the mold cavities. The words "molding vent" refer to grooves or channels, placed in the part being encapsulated, e.g. a leadframe, to accomplish the same venting action.

The invention has the advantage that it does not require the use of vents built into the mold cavities.

It is a further advantage of this invention that the effort required for mold cleaning is substantially reduced. In addition, the mold life is increased.

By means of the present invention, disposable molding vents are provided during each use of the mold, without significant additional cost.

The invention also has the advantage that it reduces the occurrence of porous plastic caused by obstructed gas vents.

The invention also provides an improved means and method for encapsulating electronic devices on leadframes having burrs or other irregularities.

The foregoing and other advantages are achieved by virtue of the fact that the vents leading from each mold cavity are built into the leadframe and not the mold. This is accomplished in a preferred embodiment by providing coined grooves in the rails making up the side portion of the tie bars or tie strips which connect together the die flags, leads, and units of the leadframe.

Brief description of the drawings

A more complete understanding of the present invention can be gained by considering the following detailed description in conjunction with the accompanying drawings, in which:

Fig. 1A is a top view of a typical ladder-type leadframe used in the construction of plastic encapsulated integrated circuits, according to the prior art.

Fig. 1B shows a first cross-section through a closed mold containing several prior art leadframes of the type shown in Fig. 1A with semiconductor die attached, according to the prior art.

Fig. 1C shows a second cross-section through the mold of Fig. 1B, and at right angles to the view of Fig. 1B, containing the prior art leadframe of Fig. 1A.

Fig. 2A is a ladder-type leaframe similar to that of Fig. 1A, but according to the present invention.

Fig. 2B is a first cross-section through a closed mold, analogous to the cross-section of Fig. 1B, but employing the leadframe of Fig. 2A and according to the present invention.

Fig. 2C is a second cross-section through the closed mold of Fig. 2B, analogous to the cross-section of Fig. 1C, but containing the leadframe of Fig. 2A, and according to the present invention.

Detailed description of the preferred embodiment

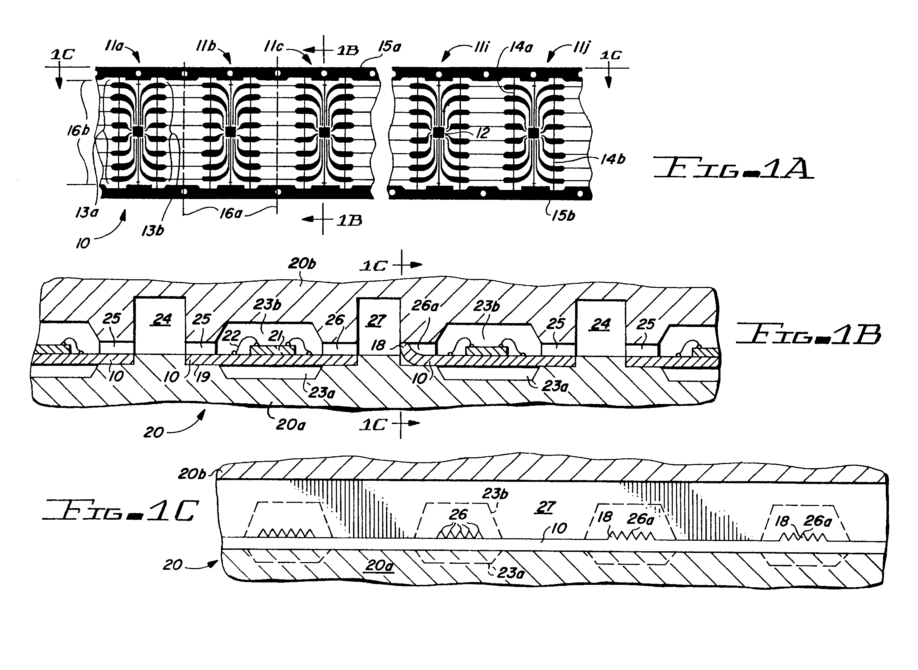

Fig. 1A illustrates ladder-type leadframe 10 according to the prior art. Figs. 1B—C show a portion of the same leadframe 10 enclosed in mold 20. Leadframe 10 comprises multiple individual device units 11a—j, connected by tie strips or tie bars 15a—b. Tie strips 15a—b are commonly called side rails. Each individual device unit comprises centrally located support means or flag 12 to which electronic device 21, for example, a semiconductor die or chip, is attached by means well-known in the art. Surrounding flag 12 are numerous leads 13a—b. Leads 13a—b and flag 12 are tied together by tie bars or side rails 14a—b and 15a—b. Leadframe 10 is typically fabricated from a single flat sheet of metal by stamping or etching. Following die bonding, wire bonding, and encapsulation, the individual device units, e.g. 11a—j, are separated from each other and from side rails 15a—b along lines 16a—b. Tie bars 14a—b are also cut away so that leads 13a—b, now supported by the plastic encapsulation, can be electrically independent.

Figs. 1B—C illustrate the situation when one or more leadframes of the type shown in Fig. 1A are placed in a mold ready for encapsulation. Mold 20 is composed of lower half 20a and upper half 20b. Leadframe 10 containing, for example, semiconductor die 21 with wire bonds 22, is placed in recess 19 of mold 20. Cavity 23a—b defines the size and location of the encapsulation which will be molded around die 21. Encapsulation of die 21 is typically accomplished by injection or transfer molding in which liquified plastic flows through central distribution channel 24 and enters individual device cavity 23a—b through orifice or gate 25. As liquified plastic enters through gate 25, the air remaining in cavity 23a—b escapes through mold vent channels 26 into vent runner 27. In the prior art, mold vent channel 26 and vent runner 27 are formed in one or both halves of mold 20.

Mold vent channels 26 are typically made in the form of small grooves (for example, see Fig. 1C) so that a minimal amount of plastic is wasted. Each time mold 20 is opened small bits of plastic break off from the encapsulated device and remain in channels 26. These must be removed from the mold by hand. This is typically done by brushing, blowing, and vacuuming, and is a labor intensive procedure. If the mold is not thoroughly cleaned, the small fragments of plastic which remain either block the mold vents and cause improper (e.g. porous) encapsulation, or become trapped between otherwise mating surfaces of the mold halves and cause damage to the mold. This appreciably shortens the mold life. A further disadvantage of the prior art leadframe and mold design is that small features of the mold such as channels 26 can undergo proportionately faster wear from the abrasive plastic, further shortening mold life. In contrast, the presence of small fragments in large vent channel 27 is relatively harmless since they cannot block the larger channel and are much less likely to lodge between mating mold faces.

Further, burrs on leadframe 10 which are formed at the sheared edges during stamping of leadframe 10, can protrude into channels 26, as is illustrated in the right half of Figs. 1B—C where burr 18 on leadframe 10 blocks mold vent channel 26a. Such burrs inhibit the escape of gases from cavity 23a—b and result in incomplete or porous plastic encapsulations.

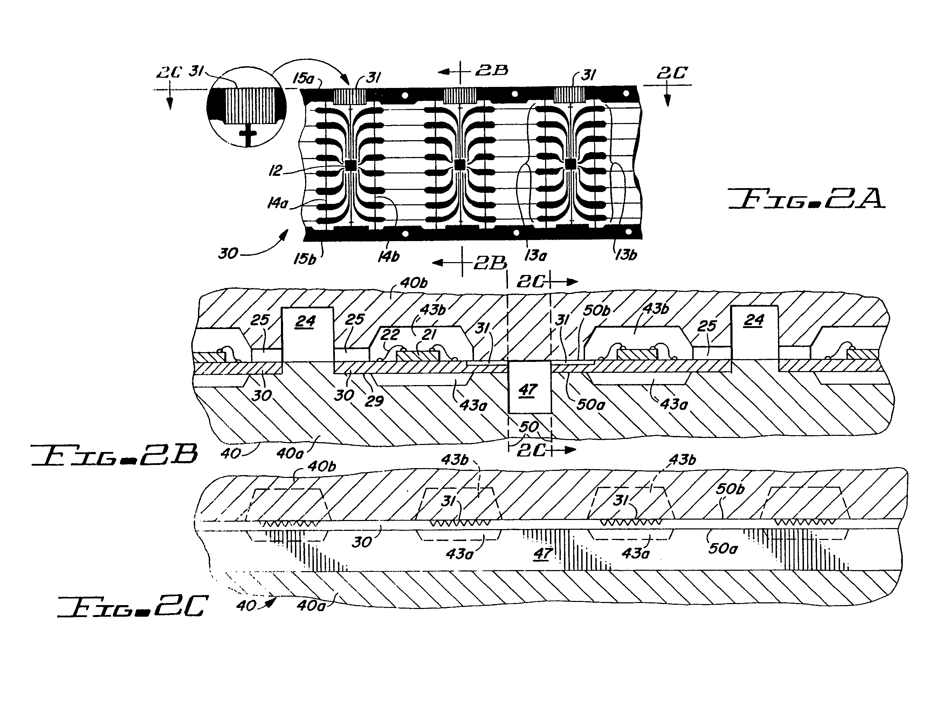

Fig. 2A shows a ladder-type leadframe similar to that in Fig. 1A but according to the present invention. Leadframe 30 of Fig. 2A differs from leadframe 10 of Fig. 1A in that leadframe 30 has integral molding vent means 31 provided in tie strip or rail 15a.

Figs. 2B—C are cross-sections of a closed mold, analogous to those shown in Figs. 1B—C, but containing the leadframe of the present invention, and modified to omit mold vent channels 26 shown in Figs. 1B—C. Lower and upper faces 50a—b of lower and upper mold halves 40a—b, respectively, seal against tie bars or strips 14a—b and side rails 15a—b which surround die support means or flag 12 containing die 21, thus defining mold cavity 43a—b. As can be seen in Figs. 2B—C, molding vent channels 31, which are illustrated as being in the form of shallow grooves or channels in leadframe 30 (see Fig. 2C), provides a route by which gas can escape from mold cavity 43a—b into vent runner 47 which connects to the outside atmosphere. With the present invention in which molding vent channels 31 are provided in leadframe 30, neither lower half 40a nor upper half 40b of mold 40 are provided with mold vent channels leading from cavity 43a—b. As used herein in connection with mold cavities, the words "non-vented" refer to the situation, as in Figs. 2B—C, where there are no mold vents built into the mold itself which lead from the cavity or cavities either directly to the outside atmosphere or to any intermediate vent runners 47.

Vent runner 47, as in the prior art, is of relatively large size and is therefore readily stripped of any plastic material which may exude through molding vent means 31 in leadframe 30. As before, the presence of plastic fragments in large vent runner 47 is not troublesome. Mold 40 contains no mold vent channels 26. Thus, mold 40 is much more readily cleaned than prior art mold 20 and further need not be cleaned as often. Additionally, since narrow vent channels 26 are no longer required, the problem of mold wear due to the abrasive mold compound flowing at high velocity through such narrow channels is avoided. Mold life is thus extended.

It will be readily apparent that mold 40 can be designed so that molding vent channels 31 terminate at the edge of mold 40, releasing the expelled gases directly into the atmosphere, in which case vent runner 47 is unnecessary. This modification is indicated by dotted lines 50. However, it is convenient to retain vent runners 47 since this arrangement permits a larger number of leadframes to be placed in the same mold, and, because of their substantial size, runners 47 are simple to clean and require cleaning less often.

As shown in Fig. 2A, vent channels 31 in leadframe 30 are desirably located in one of side rails 15a—b between the places where tie bars or strips 14a—b meet rails 15a—b, and in proximity to die flag 12, including the extension or tie strip which connects flag 12 to side rails 15a—b. As will be apparent from Figs. 2B—C, this location is adjacent cavity 43a—b and vent runner 47 when leadframe 30 is located in mold 40. Thus, molding vent channels 31 provide a pathway for escaping gases running between cavity 43a—b and vent runner 47. While the preferred embodiment of Figs. 2A—C shows molding vent channels 31 as being placed in side rail 15a, molding vent channels 31 could also be placed in rail 15b or in tie strips 14a or 14b, or a combination thereof. Vent runner 47 would, in such case, be extended to communicate with molding vent channels 31.

Electronic devices are fabricated utilizing improved leadframe 30 of Fig. 2A in the following way. Molding vent channels 31 are conveniently provided by forming a series of channels or grooves in leadframe 30 running across at least one of tie strips 14a—b and/or side rails 15a—b or the like used to seal mold 40. In this embodiment illustrated in Figs. 2A—C, vent channels 31 are located in one of side rails 15a—b. The grooves or channels comprising molding vent channels 31 may be conveniently fabricated by stamping, coining, or etching at the same time that leadframe 30 is cut from the basic flat sheet stock. These grooves or channels are formed or coined across any burrs which might exist at the edges of leadframe 30. Hence, obstruction of mold vents by burrs on the leadframe is automatically avoided with the present invention. The yield and quality loss which would otherwise result from this mold vent obstruction is likewise avoided. Little if any additional cost is required to provide molding vent channels 31 in the form of channels or grooves in leadframe 30 since only a one-time modification to the stamping dies need be made. This is a significant manufacturing advantage.

Electronic device 21 is bonded to flag 12 or leadframe 30 containing molding vent channels 31. Wire bonds 22 are provided to connect the appropriate bonding pads on electronic device 21 to leads 13a—b of leadframe 30. Techniques for performing these die attach and wire bond operations are well-known in the art.

Once die attach and wire bond have been completed, the leadframe is placed between upper and lower mold halves 40a—b and mold 40 closed. Surfaces 50a—b of mold 40 engage tie strips 14a—b and side rails 15a—b, in order to provide sealed mold cavity 43a—b surrounding electronic device 21. Plastic (not shown) is placed or injected into molde 40 by conventional techniques. It flows along runner 24 and through gate 25 into cavity 43a—b. In this process, gases present in cavity 43a—b escape through molding vent channels 31, either directly to the atmosphere or by means of vent runner 47. Following encapsulation, mold 40 is opened and leadframe 30 together with the plastic encapsulation and the accompanying flash removed from the mold. The plastic which has solidified in molding vent means 31 is removed automatically along with the portions of the leadframe in which it is embedded. No additional labor is required. Tie bars, strips, and/or rails 14a—b and 15a—b are sheared away so that leads 13a—b are electrically separated. It will be readily apparent that the plastic in molding vent channels 31 is also cut away during the shearing operation, and at no additional cost. Leads 13a—b are then formed in a conventional manner to give a finished device.

Thus it is apparent that there has been provided in accordance with this invention an improved lead frame design and improved means and method for encapsulating electronic devices, particularly semiconductor devices and integrated circuits. While the embodiments of the present invention have been described and illustrated in terms of a leadframe suitable for use with integrated circuits, those of skill in the art will recognize that the invented means and method applies to any leadframe or like object having a portion which acts as a mold seal.

Further, it is apparent that the invented means and method reduces mold cleaning cost and mold wear and extends mold life. Additionally mold vent blockage due to lead frame burrs is avoided. It is further apparent that voiding or porosity in the plastic encapsulation is reduced or eliminated by virtue of the fact that the improved lead frame provides a fresh, unblocked, disposable array of molding vents for each production cycle. These features improve manufacturing yield and finished device quality, and reduce costs.

Having thus described the invention, it will be apparent to those skilled in the art that various modifications can be made with the scope of the present invention as defined by the claims. In particular, the molding vent means may be placed in any portion of the tie bars, strips, or rails which are adjacent the mold cavity to be vented. In particular, they may be placed at the corners, ends, or sides of the package in locations which would be too small to accommodate conventional mold vent channels. Accordingly, it is intended to encompass all such modifications.

## Claims

1. A leadframe (30) for use in plastics encapsulation of electronic devices (21), comprising:

device support means (12) located in a central region of the leadframe, and

lead means (13a—b) extending from the device support means to an edge or edges of the leadframe and tie-bars (14a—b) interconnecting the lead means (13a—b), the tie-bars being connected to side rails (15a—b) characterised by:

multiple V-shaped vent channels (31) formed in a surface of the leadframe, extending across at least one of the tie-bars and/or at least one of the side rails for venting gases during the plastics encapsulation.

2. A leadframe (30) adapted for use in plastic encapsulation of electronic devices (21), comprising:

device support means (12);

lead means (13a—b) adjacent said device support means (12);

tie-bars (14a—b) connected to said device support means (12) and said lead means, adapted to seal against opposing faces of a mold (40) characterised by:

multiple V-shaped molding vent channels (31) integral with at least one of said tie-bars (14a—b) and extending across the tie-bar for venting gases during said plastic encapsulation.

3. A leadframe according to claim 1 wherein said side rails (15a, 15b) are provided, arranged in substantially parallel spaced apart relationship, wherein the vent channels (31) are formed across at least one side rail.

4. A semiconductor device comprising:

a molded unitary plastic housing;

a leadframe according to claim 1 or 2 comprising a lead means (13a—b) having portions within and without said plastic housing;

a semiconductor unit (21) secured to the device support means (12) within said plastic housing and conductively connected within said housing with portions of said lead means;

wherein said portions of said lead means extending out of said plastic housing serve as connectors for the semiconductor device and wherein said portions of said lead means (13a—b) extending outside said plastic housing are joined by at least two severable tie strip means (14a—b, 15a—b) integral therewith at a point between the plastic housing and the end of each said portion extending outside said plastic housing for retaining said extending portions parallel with one another during molding in a mold cavity (43a—b) and serving as a mold sealing point in such molding, wherein at least one of said at least two tie strip means (14a—b, 15a—b) contains vent channels (31) extending across the tie-strip means.

5. A leadframe according to any one of claims 1 to 3, in combination with a mold, the leadframe being mounted between two parts of the mold and the tie-bars or rails acting as mold seal means (14a-b), 15a—b), the mold having a cavity around the device support means, wherein the vent channels (31) provided in the surface of the leadframe, extend across the mold seal means (14a—b, 15a—b) so as to allow gases in the cavity to vent out of the mold.

6. A method for plastic encapsulation of electronic devices on a leadframe in a mold, comprising:

providing a leadframe (30) having multiple V-shaped molding vent means integral thereto (31) the lead frame carrying the electronic device;

locating said leadframe (30) between opposing faces (40a, 40b) of said mold (40) said mold having a cavity to accommodate the electronic device;

closing said mold (40) to engage said leadframe (30) at least in part as a mold closure seal whereby the multiple V-shaped molding vent means extend between the cavity and outside atmosphere;

either before or after said locating or closing step, introducing plastic into said mold (30) whereby gases are vented from said cavity via said vent means (31).

7. A method according to claim 8, wherein the vent means are formed by stamping, coining or etching prior to location of the leadframe in the mold.

## Patentansprüche

1. Leiterrahmen (30) zur Verwendung beim Vergießen elektronischer Vorrichtungen (21) in Plastikmaterial, enthaltend:

eine Vorrichtungshalteeinrichtung (12), die in einem mittleren Bereich des Leiterrahmens angeordnet ist, und

Leitereinrichtungen (13a—b), die sich von der Vorrichtungshalteeinrichtung zu einem Rand oder zu Rändern des Leiterrahmens erstrecken, und

Zugstäbe (14a—b), die die Leitereinrichtungen (13a—b) miteinander verbinden, welche Zubstäbe mit Seitenschienen (15a—b) verbunden sind, gekennzeichnet durch:

mehrere V-förmige Entlüftungskanäle (31), die in einer Oberfläche des Leiterrahmens ausgebildet sind und sich über wenigstens einen der Zugstäbe und/oder wenigstens eine der Seitenschienenen erstrecken, um beim Vergießen mit Plastikmaterial Gase zu entlüften.

2. Leiterrahmen (30), der zur Verwendung beim Vergießen elektronischer Vorrichtungen (21) mit Plastikmaterial eingerichtet ist, enthaltend:

eine Vorrichtungshalteeinrichtung (12);

Leitereinrichtungen (13a—b) benachbart der Vorrichtungshalteeinrichtung (12);

Zugstäbe (14a—b) die mit der Vorrichtungshalteeinrichtung (12) und mit den Leitereinrichtungen verbunden sind und dazu eingerichtet sind, an den gegenüberliegenden Flächen einer Form (40) abzudichten, gekennzeichnet durch:

mehrere V-förmige Gußentlüftungskanäle (31), die integral mit wenigstens einem der Zugstäbe (14a—b) ausgebildet sind und sich über den Zugstab estrecken, um beim Vergießen mit Plastikmaterial Gase zu entlüften.

3. Leiterrahmen nach Anspruch 1, bei dem die Seitenschienen (15a, 15b) im wesentlichen parallel zueinander im Abstand angeordnet sind, wobei die Entlüftungskanäle (31) über wenigstens eine Seitenschiene ausgebildet sind.

4. Halbleitervorrichtung, enthaltend:

ein gegossenes, einstückiges Plastikgehäuse;

einen Leiterrahmen nach Anspruch 1 oder 2 mit Leitereinrichtungen (13a—b), die Abschnitte innerhalb und außerhalb des Plastikgehäuses aufweisen;

eine Halbleitereinheit (21), die an der Vorrichtungshalteeinrichtung (12) innerhalb des Plastikgehäuses befestigt ist und leitfähig innerhalb des Gehäuses mit Abschnitten der Leitereinrichtungen verbunden ist;

wobei die Abschnitte der Leitereinrichtungen, die sich außerhalb des Plastikgehäuses erstrecken, als Verbinder für die Halbleitervorrichtung dienen und wobei die Abschnitte der Leitereinrichtungen (13a—b), die sich außerhalb des Plastikgehäuses erstrecken, durch wenigstens zwei abtrennbare Zugstreifeneinrichtungen (14a—b, 15a—b), die integral mit ihnen ausgebildet sind, an einem Punkt zwischen dem Plastikgehäuse und dem Ende eines jeden dieser Abschnitte, die sich außerhalb des Plastikgehäuses erstrecken, verbunden sind, um die sich erstreckenden Abschnitte parallel zueinander beim Gießen in einem Formhohlraum (43a—b) zu halten, und die als Formabdichtungspunkt beim Gießen dienen, wobei wenigstens einer der wenigstens zwei Zugstreifeneneinrichtungen (14a—b, 15a—b) Entlüftungskanäle aufweist, die sich über die Zugstreifeneinrichtungen erstrecken.

5. Leiterrahmen nach einem der Ansprüche 1 bis 3 in Kombination mit einer Form, wobei der Leiterrahmen zwischen zwei Teilen der Form befestigt ist und die Zugstäbe oder Schienen als Formdichtungseinrichtungen (14a—b, 15—b) wirken, wobei die Form einen Hohlraum um die Vorrichtungshalteeinrichtung aufweist, wobei die Entlüftungskanäle (31), die in der Oberfläche des Leiterrahmens ausgebildet sind, sich über die Formdichtungseinrichtung (14a—b, 15a—b) erstrecken, um es den Gasen in dem Hohlraum zu ermöglichen, aus der Form zu entweichen.

6. Verfahren zum Vergießen elektronischer Vorrichtungen an einem Leiterrahmen in einer Form mit Plastikmaterial, enthaltend:

Bereitstellen eines Leiterrahmens 30 mit mehreren V-förmigen Gießentlüftungseinrichtungen (31), die integral mit ihm ausgebildet sind, wobei der Leiterrahmen die elektronische Vorrichtung trägt;

Anordnen des Leiterrahmens (30) zwischen gegenüberliegenden Flächen (40a, 40b) der Form (40), wobei die Form einen Hohlraum zur Aufnahme der elektronischen Vorrichtung aufweist;

Schließen der Form (40), um den Leiterrahmen (30) wenigstens teilweise als eine Formverschlußdichtung zu ergreifen, wodurch sich die vielen V-förmigen Gußentlüftungseinrichtungen zwischen dem Hohlraum und der äußeren Atmosphäre erstrecken.

entweder vor oder nach dem Anordnungs- oder Schließschritt,

Einführen von Plastikmaterial in die Form (30), wodurch Gase aus dem Hohlraum durch die Entlüftungseinrichtung (31) entlüftet werden.

7. Verfahren nach Anspruch 6, bei dem die Entlüftungseinrichtungen durch Stanzen, Prägen oder Ätzen vor dem Anbringen des Leiterrahmens in der Form ausgebildet werden.

**Revendications**

1. Cadre de connexion (30) pour emploi lors de l'encapsulation, dans le plastique, de dispositifs électroniques (21), comportant

des moyens (12) formant supports du dispositif, situés dans une région centrale du cadre de connexion et

des moyens (13a—b) formant conducteurs s'étendant depuis les moyens formant supports du dispositif jusqu'à un bord ou jusqu'à des bords du cadre de connexion, ainsi que des barres d'attache (14a—b) interconnectant les moyens formant conducteurs (13a—b), les barres d'attache étant connectées aux rails latéraux (15a—b), caractérisé par:

de multiples canaux d'évent (31), en forme de V, formés dans une surface du cadre de connexion, s'étendant d'un côte à l'autre d'au moins l'une des barres d'attache et/ou d'au moins l'un des rails latéraux pour l'échappement des gaz au cours de l'encapsulation dans le plastique.

2. Cadre de connexion (10) conçu pour emploi lors de l'encapsulation, dans le plastique, de dispositifs électroniques (21), comportant:

des moyens (12) formant supports des dispositifs;

des moyens (13a—b) formant conducteurs, voisins desdits moyens (12) formant supports du dispositif;

des barres d'attache (14a—b) connectées auxdits moyens (12) formant supports du dispositif et auxdits moyens formant conducteurs, conçues pour réaliser l'étanchéité à l'égard des faces opposées d'un moule (40),

caractérisé par:

de multiples canaux d'évent de moulage (31), en forme de V, solidaires d'au moins l'une desdites barres d'attache (14a—b) et s'étendant de part de d'autre de la barre d'attache pour l'échappement des gaz au cours de ladite encapsulation par le plastique.

3. Cadre de connexion selon la revendication 1, dans lequel lesdits rails latéraux (15a, 15b) sont prévus, disposés substantiellement parallèlement l'un à l'autre et à une certaine distance l'un de l'autre, et dans lequel les canaux d'évent (31) sont formés d'un côté à l'autre moins un rail latéral.

4. Dispositif semi-conducteur comportant:

un boîtier en plastique d'une seule pièce, moulé;

un cadre de connexion conforme à la revendication 1 ou 2 comprenant des moyens (13a—b) formant conducteurs présentant des portions à l'intérieur et à l'extérieur dudit boîtier plastique;

un dispositif semi-conducteur (21) fixé au moyen (12) support du dispositif, à l'intérieur dudit boîtier plastique et connecté, au point de vue conduction, à l'intérieur dudit boîtier, avec les portions desdits moyens formant conducteurs;

dans lequel lesdites portions desdits moyens formant conducteurs s'étendant hors dudit boîtier plastique servent de connecteurs pour le dispositif semi-conducteur et dans lequel lesdites portions desdits moyens (13a—b) formant conducteurs s'étendant à l'extérieur dudit boîtier plastique sont réunies par au moins deux moyens (14a—b, 15a—b), formant rubans d'attache sectionnables, solidaires avec elles en un point situé entre le boîtier plastique et l'extrémité de chaque dite portion s'étendant à l'intérieur dudit boîtier plastique, pour retenir parallèlement l'une à l'autre lesdites portions, s'étendant à l'extérieur, au cours du moulage, dans une cavité (43a—b) du moule et servant de point d'étanchéité du moule au cours de ce moulage, dispositif dans lequel au moins l'un desdits moyens (14a—b, 15a—b) formant rubans d'attache, dont il y a au moins deux, contient des canaux d'évent (31) s'étendant d'un côté à l'autre des moyens formant rubans d'ataché.

5. Cadre de connexion selon l'une quelconque des revendications 1 à 3, en combinaison avec un moule, le cadre de connexion étant monté entre deux parties du moule et les barres d'attache ou les rails agissant comme moyens (14a—b, 15a—b) réalisant l'étanchéité du moule, le moule présentant une cavité autour des moyens formant supports de dispositif, dans lequel les canaux d'évent (31) prévus dans la surface du cadre de connexion s'étendent d'un côté à l'autre des moyens (14a—b, 15a—b) réalisant l'étanchéité du moule, de façon à permettre aux gaz qui se trouvent dans la cavité de s'échapper hors du moule.

6. Procédé d'encapsulation dans le plastique de dispositifs électroniques sur un cadre de connexion placé dans un moule, comportant:

le fait de disposer d'un cadre de connexion (30) présentant, solidaires avec lui, de multiples moyens (31) formant évents de moulage, en forme de V, ledit cadre de connexion portant le dispositif électronique;

le fait de placer ledit cadre de connexion (10) entre les faces opposées (40a, 40b) dudit moule (40), ledit moule comportant une cavité pour recevoir le dispositif électronique;

le fait de fermer ledit moule (40) pour venir en prise avec ledit cadre de connexion (30) qui forme alors au moins en partie garniture d'étanchéité du moule, étant précisé que les multiples moyens formant évents de moulage en forme de V s'étendent entre la cavité et l'atmosphère extérieure;

soit avant, soit après ladite phase de mise en place ou de fermeture, le fait d'introduire du plastique dans ledit moule (30), ce par quoi les gaz s'échappent de ladite cavité par l'intermédiaire desdits moyens (31) formant évents.

7. Procédé selon la revendication 8, dans lequel les moyens formant évents sont formés par estampage, emboutissage, ou attaque chimique, avant mise en place du cadre de connexion dans le moule.

Fig-1A

Fig-1B

Fig-1C

FIG.2A

FIG.2B

FIG.2C

EP 0 130 552 B1